# FASCICULE DE BREVET EUROPEEN

(11) **EP 1 802 789 B1**
(45) Date de publication et mention de la délivrance du brevet: **18.02.2009**
(21) Numéro de dépôt: 05800584.4
(22) Date de dépôt: 30.09.2005
(51) Int. Cl.: C25F 3/14, H01L 31/18

(54) **DISPOSITIF DE GRAVURE D'UNE COUCHE CONDUCTRICE ET PROCEDE DE GRAVURE**
VORRICHTUNG ZUM ÄTZEN EINER LEITFÄHIGEN SCHICHT UND ÄTZVERFAHREN
DEVICE FOR ETCHING A CONDUCTIVE LAYER AND ETCHING METHOD

(30) Priorité: 19.10.2004 FR 0452369
(43) Date de publication de la demande: 04.07.2007
(73) Titulaire: SAINT-GOBAIN GLASS FRANCE, 92400 Courbevoie (FR)
(72) Inventeur: MAZZARA, Christophe, F-45160 Olivet (FR); GIRARD, Jaona, F-93270 SEVRAN (FR)
(74) Mandataire: Aupetit, Muriel J. C.
(86) Numéro de dépôt international: PCT/FR2005/050799
(87) Numéro de publication internationale: WO 2006/042985

(56) Documents cités:
- EP-A- 0 896 373
- EP-A- 1 322 145
- FR-A- 2 325 084
- US-A1- 2004 045 930
- US-B1- 6 379 569

## Description

L'invention concerne un dispositif pour graver des couches déposées sur des substrats transparents du type substrat verrier, et plus particulièrement des couches au moins légèrement conductrices électriquement en vue d'obtenir des éléments conducteurs, tels que des électrodes. Elle est également relative à procédé de gravure de telles couches conductrices.

L'invention s'intéresse notamment aux couches à base d'oxyde métallique dopé ou à base de métal, et de préférence celles qui par leurs caractéristiques propres et leurs épaisseurs sont transparentes. Elle n'exclut cependant pas les couches opaques.

Beaucoup de produits à base de substrats verriers ont en effet besoin d'éléments conducteurs selon des motifs particuliers, avec une bonne, voire une très haute résolution. C'est par exemple le cas des électrodes des verres d'écrans émissifs du type écran plat, des électrodes des cellules photovoltaïques ou encore des réseaux d'éléments conducteurs des vitrages chauffants ou incorporant des antennes.

Il est connu de la demande de brevet EP 1 322 145 (également brevet US 6 379 569) une technique de gravure chimique de couches d'oxyde métallique conducteur. On dépose un masque sur la couche à graver, on attaque la couche dans les zones dépourvues du masque en mettant en contact avec ces zones une solution à pH acide ou à pH alcalin et en projetant par dessus du zinc ou de l'aluminium pulvérulent, puis on nettoie la couche par rinçage à l'aide d'une solution à base d'eau et/ou de solvants organiques, et enfin on retire le masque.

Cependant, lorsqu'il s'agit d'appliquer ce procédé pour des applications nécessitant de fortes résolutions de gravure, le résultat n'est pas optimal. On observe une inhomogénéité de la gravure avec notamment l'apparition du phénomène de surgravure, i.e. que la couche est gravée même sous le masque, ce qui engendre une distance non constante entre les électrodes rendant le substrat inutilisable.

Par ailleurs, lorsqu'il s'agit d'une couche à base d'oxyde d'indium dopé à l'étain (ITO), des résidus de gravure tels que les particules d'ITO apparaissent, et un simple rinçage à l'eau n'est pas suffisant pour les enlever. Un rinçage avec un détergent spécifique est nécessaire ce qui n'est pas sans augmenter le coût de fabrication du produit final.

L'invention a donc pour but de remédier à ces inconvénients en proposant un nouveau procédé de gravure chimique d'une couche à propriétés de conduction électrique nécessitant au moins deux solutions de gravure qui soit plus performant, ainsi qu'un dispositif qui soit aisé de mise en oeuvre pour assurer une qualité de gravure à l'attente de l'application concernée et une production de manière industrielle.

Au sens de l'invention, on comprend par « à propriétés de conduction électrique », des couches présentant une résistivité d'au plus 4.10⁻²Ω.cm, notamment d'environ 4.10-³ à 4.10⁻⁴Ω.cm au moins. Sont visées plus particulièrement les couches d'au plus 1000 Ω/carré et de préférence d'au plus 500 Ω/carré, pour des épaisseurs de couche généralement comprises entre 50 et 1000 nm.

La gravure de telles couches permet en effet d'obtenir des réseaux d'électrodes d'applications variées. Cependant, il va de soi que la technique de gravure de l'invention peut tout aussi bien s'appliquer à des couches peu ou pas conductrices du tout, du type diélectrique, oxyde métallique non dopé par exemple, s'il y a un intérêt à les graver, notamment dans un but décoratif.

Selon l'invention, le dispositif pour graver chimiquement une couche à propriétés de conduction électrique sur un substrat transparent, comporte des moyens de support du substrat et des moyens de projection d'une solution, et est caractérisé en ce que les moyens de projection consistent en une multiplicité de buses qui sont agencées au-dessus du substrat et qui sont destinées à projeter simultanément sur la couche à graver au moins deux solutions, soit de manière indépendante l'une de l'autre, soit selon un mélange effectué au niveau des buses ou en amont de buses dans un laps de temps avant la projection ne dépassant pas trente secondes.

Les buses sont portées par au moins une rampe oblongue. Ainsi, les moyens de projection peuvent comporter au moins une rampe qui s'étend selon l'extension la plus grande du substrat et correspond en longueur sensiblement à cette extension. Par exemple, ils comportent au moins deux rampes qui s'étendent selon l'extension la plus grande du substrat et qui sont agencées selon un écartement correspondant sensiblement à l'extension la plus petite du substrat. Les moyens de projection peuvent aussi comporter au moins une rampe qui s'étend selon l'extension la plus petite du substrat et correspond en longueur sensiblement à cette extension. Ou encore, les moyens de projection peuvent comporter au moins deux rampes qui s'étendent selon l'extension la plus grande du substrat et qui sont agencées selon un écartement correspondant sensiblement à l'extension la plus petite du substrat, ainsi qu'au moins une rampe supplémentaire qui s'étend transversalement aux deux autres rampes.

Dans une autre variante, les buses sont réparties de manière à couvrir une surface équivalente à la surface du substrat.

Selon une caractéristique, les buses pulvérisent au moins une solution de manière continue ou alternative.

Selon une autre caractéristique, les solutions peuvent être projetées pour un même substrat non pas en une seule fois mais selon des cycles de délivrance. Ainsi, les deux solutions peuvent être projetées pendant un laps de temps correspondant à un cycle de délivrance, le temps entre deux cycles étant par exemple occupé à projeter une solution unique, soit de l'une des deux solutions, soit d'une autre solution telle qu'une solution de rinçage.

L'alimentation des buses peut se faire de différentes façons. Chaque rampe comporte un conduit d'alimentation d'une solution distincte, les buses d'une même rampe délivrant la même solution. En variante, au moins une rampe comporte au moins deux conduits d'alimentation de respectivement deux solutions distinctes, qui sont respectivement délivrées dans la multitude de buses, de manière indépendante ou bien concomitamment. On peut aussi envisager que les deux rampes s'étendant selon l'extension la plus grande du substrat sont alimentées par une même solution, tandis que la ou les rampes supplémentaires transversales sont alimentées par une autre solution distincte.

Les moyens de support du substrat sont aptes à défiler sous les buses qui sont fixes, et/ou les buses sont aptes défiler au-dessus du substrat qui est en position fixe ou qui défile. Par exemple, le substrat est fixe, tandis que certaines buses sont fixes pour délivrer une première solution et d'autres buses sont mobiles pour délivrer une seconde solution. On peut ainsi concevoir des rampes fixes avec des buses qui délivrent une première solution, tandis qu'au moins une rampe est mobile au-dessus du substrat apte à effectuer plusieurs allers et retours et délivrant par ses buses la seconde solution.

Selon une autre caractéristique, les buses sont disposées à une hauteur du substrat comprise entre 1 et quelques dizaines de centimètres.

De préférence, le dispositif comporte un caisson couvrant les buses et le substrat lors de la pulvérisation des solutions.

Le dispositif de l'invention est en particulier utilisé pour un substrat comportant une couche à base d'oxyde d'étain à graver et les buses délivrent simultanément une solution d'acide chlorhydrique et une solution à base de zinc.

La solution à base de zinc est une solution dans laquelle les particules de zinc sont dispersées dans de l'eau, la solution étant mélangée en continu par un système mécanique rotatif, lors de son alimentation jusqu'aux buses.

Par ailleurs, les moyens de projection sont adaptés à délivrer une solution de rinçage, les moyens de projection pour le rinçage étant fixes ou mobiles au-dessus du substrat.

Le dispositif de gravure selon l'invention peut ainsi graver des couches très diverses, notamment des couches d'oxyde métallique dopé tel que l'oxyde d'étain dopé au fluor SnO₂:F, l'oxyde d'étain dopé à l'arsenic SnO₂:As, ou à l'antimoine SnO₂:Sb, ou avec d'autres métaux dopants de la colonne Va du tableau périodique. Il peut aussi graver des couches à base d'oxyde d'indium dopé à l'étain ITO, ou éventuellement des couches en métal, en argent par exemple. Ces couches peuvent être plus ou moins épaisses, par exemple de quelques nanomètres à quelques centaines de nanomètres. Il peut ainsi s'agir de couches de 20 à 1000 nm, notamment d'au moins 40 nm, par exemple de 200 à 380 nm.

En particulier, le dispositif peut être utilisé pour un substrat comportant une couche à base d'oxyde d'étain à graver et les buses délivrent simultanément une solution d'acide chlorhydrique et une solution à base de zinc.

L'invention a également pour objet un procédé de gravure chimique d'une couche à propriétés de conduction électrique, de type oxyde métallique dopé, sur un substrat transparent de type verrier, comportant au moins une étape de dépôt d'un masque sur la couche à graver, une étape d'attaque de la couche dans les zones dépourvues du masque qui consiste à mettre en contact les zones de la couche avec une première solution à pH acide ou à pH alcalin, et à projeter une seconde solution de zinc ou respectivement d'aluminium, caractérisé en ce que la première solution et la seconde solution sont projetées simultanément sur les zones dépourvues de masque.

Avantageusement, les deux solutions sont pulvérisés simultanément de manière indépendante, ou bien simultanément selon un mélange effectué au moment de la projection ou dans un laps de temps avant la projection ne dépassant pas les trente secondes. En effet, si les deux solutions sont mélangées, elles ne doivent pas l'être trop tôt en amont de la pulvérisation, les inventeurs ayant mis en évidence que la gravure a lieu de manière optimale lors de la mise en contact des deux solutions.

En utilisant le dispositif de l'invention décrit ci-dessus pour parvenir au procédé de l'invention, il permet de pulvériser simultanément les deux solutions distinctes de façon à réaliser efficacement leur mélange lors de leur dépôt sur le substrat afin d'assurer une gravure homogène.

De préférence, les deux solutions sont pulvérisées par une technique de spray, i.e. sous forme de gouttelettes. Les gouttelettes, qui peuvent par exemple s'apparenter à un brouillard ou à une pluie plus drue, présentent une finesse qui dépend en particulier du type de couche à graver, de l'épaisseur, de la hauteur séparant les buses du substrat, de la vitesse de défilement du substrat par rapport aux buses.

Selon une caractéristique, le procédé grave des couches à base d'oxyde métallique dopé, notamment des couches à base d'oxyde d'étain dopé au fluor, à l'arsenic ou à l'antimoine, à base d'oxyde d'indium dopé à l'étain ITO.

La nature de la couche et son épaisseur sont à prendre en compte pour ajuster les concentrations des solutions d'attaque corrosive, les temps de gravure (généralement de l'ordre d'au plus quelques minutes). Il s'est avéré que le procédé selon l'invention était particulièrement efficace pour graver des couches à base de SnO₂, notamment en SnO₂:F, jusque-là connues pour être au contraire très « dures », résistantes chimiquement, et donc difficiles à graver. Cela ouvre ainsi un champ d'applications beaucoup plus diversifié pour ce type de couche, tout particulièrement dans l'électronique pour faire des électrodes, à la place d'électrodes usuellement en ITO, performantes mais nécessitant généralement des traitements de recuit pour obtenir le niveau de conduction électrique requis.

Selon une caractéristique, le zinc ou l'aluminium de la solution est en suspension dans un ou plusieurs solvants organiques et/ou aqueux éventuellement munis au moins d'additifs modificateurs de rhéologie.

En ce qui concerne la solution à pH acide, celle-ci peut comprendre au moins un solvant aqueux ou organique de type alcoolique, et de préférence être à base d'un mélange hydroalcoolique du type eau + éthanol ou isopropanol. Il s'est en effet avéré qu'ajouter de l'alcool à l'eau contenant l'acide permettait de mieux contrôler la taille des bulles d'hydrogène créées au contact du zinc, notamment de diminuer la taille de ces bulles pour faire une attaque plus « douce » de la couche (et éviter ainsi tout risque de décollement du masque soumis à l'action mécanique des bulles de H₂). En complément ou à la place de l'alcool, cet effet peut aussi être obtenu en ajoutant des additifs appropriés du type surfactant, anionique, cationique ou non-ionique. Si la solution est à pH basique, elle comprend au moins un solvant aqueux, alcoolique ou hydroalcoolique, et une base forte du type Na OH, et éventuellement des additifs du type surfactants.

Bien entendu, le procédé comporte après l'étape d'attaque, un traitement de nettoyage du substrat comportant la couche, et le retrait du masque.

Le nettoyage peut par exemple consister à rincer la couche, par spray ou par immersion du substrat, à l'aide d'une solution à base d'eau et/ou de solvants organiques.

Le retrait du masque peut se faire de différentes façons. De façon non limitative, on peut d'abord choisir une voie chimique, en le dissolvant dans un solvant approprié, notamment essentiellement organique. Cela peut être du toluène, de l'essence de térébenthine, du trichlorométhane ou de l'acétate de butyle.

Si on ne souhaite pas à avoir à retraiter d'effluents organiques, il vaut mieux privilégier d'autres voies : il peut s'agir d'un traitement par ultrasons, plutôt réservé cependant à des substrats de dimensions modestes. Il peut aussi s'agir d'un traitement thermique, en envoyant, par exemple sur le substrat en défilement une lame d'air chaud : la lame vient ramollir le masque qui devient liquide et est évacué par le souffle d'air. Une autre solution consiste à faire passer le substrat dans un four, par exemple à au moins 250°C, notamment à des températures de l'ordre de 400 à 450°C pour brûler le masque et le détruire. L'avantage d'un tel traitement à très haute température est qu'il peut en fait se faire concomitamment à un autre traitement thermique que doit subir par ailleurs le substrat ou l'un ou l'autre des revêtements dont il peut être muni, indépendamment du procédé de gravure. C'est notamment le cas généralement pour les substrats verriers utilisés dans l'électronique, par exemple pour ceux entrant dans la constitution d'écrans émissifs, où les verres doivent subir au moins un traitement thermique à haute température visant à les stabiliser dimensionnellement.

Une autre technique consiste à ramollir le masque par un traitement thermique à température modérée pour faciliter son décollement, puis à le peler, par traction mécanique.

L'invention a également pour objet l'utilisation du dispositif ou l'application du procédé à la fabrication d'électrodes/éléments conducteurs dans différents domaines. Il peut s'agir de l'industrie verrière, par exemple en vue de fabriquer des réseaux conducteurs pour vitrage chauffant par effet Joule, ou des vitrages incorporant des antennes. Il peut s'agir aussi de l'industrie des cellules photovoltaïques. Enfin, il peut s'agir de l'industrie électronique, en vue de fabriquer des faces avant ou faces arrière d'écrans émissifs du type écran plat, écran dit écran plasma, ou encore des écrans tactiles, et plus généralement tout type d'écran/vitrage susceptible de recevoir, transmettre ou d'émettre des rayonnements, notamment de la lumière visible.

L'invention sera décrite ci-après plus en détails à l'aide d'exemples non limitatifs illustrés par les figures suivantes :
- la figure 1 est une vue en coupe d'un substrat avant gravure;
- la figure 2 représente le substrat de la figure 1 après gravure ;
- les figures 3 à 6 illustrent respectivement quatre variantes de réalisation non limitatives d'un dispositif de l'invention.

Dans toute la suite de la description détaillée, on convient que les substrats pris à titre d'exemple sont des substrats verriers flottés d'environ 2,8 mm d'épaisseur, en vue de constituer des faces avant et arrière d'écrans émissifs du type écran plasma.

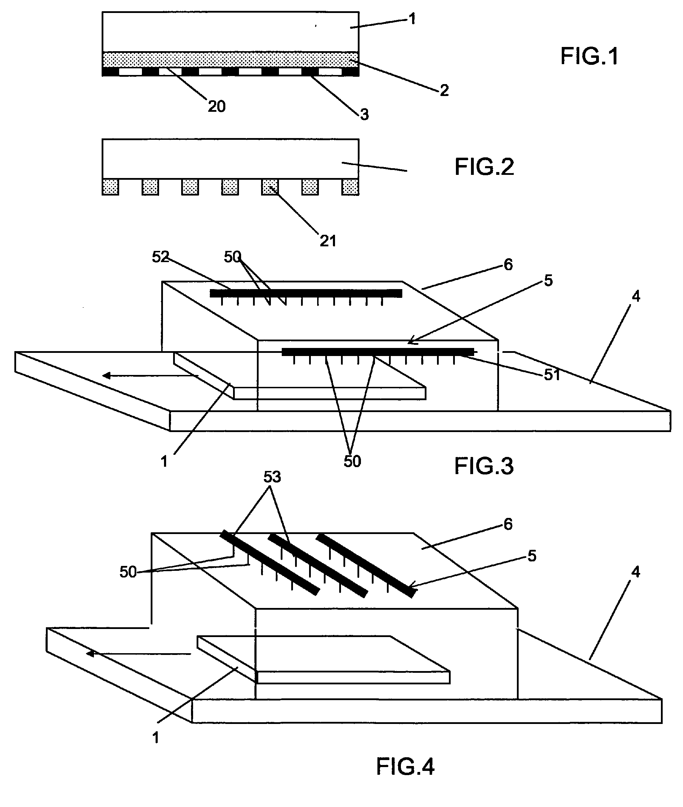

La figure 1 illustre un substrat 1 transparent de type verrier comportant une couche 2 à propriétés de conduction électrique, un masque 3 à motifs déposé sur la couche 2 à graver, le masque faisant apparaître des zones 20 non recouvertes qui sont destinées à être gravées.

Le but est d'obtenir une gravure de haute résolution des couches pour former ici des électrodes 21 (figure 2) sous forme de bandes parallèles de 100 cm de long et de 500 µm de large par exemple. Ces bandes sont par exemple espacées entre elles de 500 µm.

Pour un exemple d'application à des écrans plasma, les électrodes à former peuvent être des lignes parallèles de 300µm de large et espacées de 100µm, ou des lignes parallèles présentant des motifs complexes à l'échelle du pixel qui permettent d'améliorer la décharge plasma et jouer ainsi sur la luminosité de l'écran, ou bien encore les électrodes peuvent présenter une géométrie complexe telle que des formes du type nids d'abeilles.

La couche déposée est par exemple de type oxyde métallique dopé présentant une épaisseur entre 100 et 1000 nm d'épaisseur selon le type d'application, qui a été déposée, soit par une technique du type pyrolyse en phase gazeuse (appelée aussi CVD pour Chemical Vapor Déposition) directement en continu sur le ruban de verre float, soit en reprise sur des substrats verriers découpés.

Les étapes du procédé de gravure de l'invention sont les suivantes.

On part du substrat verrier 1 découpé et façonné de façon appropriée, recouvert de la couche 2.

On dépose directement sur la totalité de la couche le masque 3 à base de résine dite « photoresist », dont l'épaisseur peut notamment varier de 3 à 60 µm. Le procédé de dépôt du masque est bien connu de l'homme de l'art ; un mode de réalisation est par exemple décrit dans le brevet américain US 3 837 944. Le masque 3 présente un motif, tel qu'ici sous forme de bandes parallèles.

La gravure de la couche 2 est à effectuer sur les zones 20 mises à nu et dépourvues de masque qui constituent dans leur globalité, également des bandes parallèles.

Aussi, on projette sur le substrat par pulvérisation sous forme de spray au moins deux solutions, à l'aide du dispositif que nous décrirons plus loin de manière à détruire la couche 2 dans les zones 20 non masquées. Lorsque deux solutions distinctes sont nécessaires pour assurer la gravure, par exemple pour une couche d'oxyde d'étain dopé au fluor (SnO₂ :F), le dispositif de l'invention permet de pulvériser ces deux solutions simultanément.

On rince ensuite le substrat dans un bain constitué par exemple d'un mélange d'eau et éventuellement d'alcool tel que de l'éthanol. Dans une variante de rinçage, on peut pulvériser le rinçage au-dessus du substrat, par exemple à l'aide de buses similaires aux buses 50, qui peuvent être fixes et/ou mobiles au-dessus du substrat telles qu'agencées sur une rampe mobile effectuant des allers et retours.

On retire enfin le masque 3, par exemple, par immersion du substrat 1 dans un bain de trichlorométhane ou par un traitement thermique du substrat dans un four approprié à 450°C pendant 30 minutes, de façon à obtenir une couche gravée selon le motif 21.

Les figures 3, 4, 5 et 6 illustrent schématiquement quatre variantes respectives de réalisation de dispositifs selon l'invention de mise en oeuvre de l'étape de pulvérisation des solutions nécessaires à la gravure. Ces variantes ne sont pas limitatives et d'autres réalisations de dispositifs peuvent être imaginées de manière à pulvériser au moins deux solutions simultanément selon l'invention.

Un ou plusieurs substrats 1 non gravés sont déposés sur des moyens de support 4 aptes à défiler et éventuellement à stopper, tels qu'un tapis roulant pour permettre au substrat de défiler ou bien d'être positionné momentanément sous des moyens de projection 5 destinés à pulvériser au moins deux solutions de manière simultanée. Les moyens de projection 5 sont agencés à l'intérieur d'un caisson de protection 6 qui est ouvert à ses extrémités pour la progression du substrat depuis l'entrée jusqu'à la sortie dudit caisson.

Il est aussi possible d'envisager que le substrat reste fixe tandis que les moyens de projection défilent au-dessus du substrat, ou encore que le substrat comme les moyens de projection soient en mouvement à des vitesses appropriées pour réaliser la gravure.

Les moyens de projection 5 consistent en une multiplicité de buses 50, qui sont ici pour l'exemple de lignes parallèles à graver, alignées et supportées par une ou plusieurs rampes oblongues. Mais les buses peuvent être supportées autrement et agencées par rapport à la surface du substrat d'une manière différente selon le motif à graver.

Dans un mode préféré pour lequel le substrat reste en position fixe sous les moyens de projection 5, les buses sont réparties sur une surface équivalente à la surface du substrat.

Les orifices de sortie des buses peuvent présenter diverses géométries selon le type de jet à pulvériser, par exemple conique ou plat, et diverses dimensions selon la finesse des gouttes désirée.

Les buses peuvent avantageusement être orientables pour différencier d'une buse à l'autre, d'une même rampe ou de chacune des rampes, la direction du jet de pulvérisation vers le substrat.

L'actionnement des buses peut être alternatif ou continu selon leur disposition au-dessus du substrat. Néanmoins, au moins une pluralité de buses sur l'ensemble agencé, distribue au moins les deux solutions simultanément.

Une buse est soit dédiée à une solution unique ou bien est apte à délivrer le mélange des deux solutions, mélange obtenu au niveau de la buse pour que l'interaction des deux solutions se fasse au plus tôt de la projection sur le substrat, ou bien en amont de la buse mais dans un laps de temps ne dépassant pas les trente secondes avant la délivrance au travers de celle-ci.

L'homme du métier adaptera les divers paramètres intervenant dans le procédé selon le type de couche à graver et l'épaisseur de la couche, à savoir, la vitesse de défilement du substrat et/ou des buses, la hauteur séparant le substrat des buses, l'orientation des buses, la dimension et la géométrie des orifices des buses, le débit des solutions à projeter...

Dans la variante de réalisation de la figure 3, les moyens de projection 5 comportent au moins deux rampes oblongues parallèles 51 et 52 qui s'étendent selon la plus grande extension du substrat, dans la direction de son défilement, et qui sont écartées d'une distance sensiblement équivalente à la largeur du substrat.

Dans le cas d'une gravure nécessitant une copulvérisation avec deux solutions distinctes, les buses d'une première rampe peuvent être alimentées par une première solution tandis que les buses de la rampe parallèle sont alimentées par la seconde solution.

Il est aussi possible d'envisager que chaque rampe soit alimentée par les deux solutions via deux conduits d'alimentation, chacune des solutions arrivant de manière partagée jusqu'aux buses de l'ensemble de la rampe.

La figure 4 illustre une autre variante de réalisation qui comporte une pluralité de rampes oblongues 53 qui sont pourvues de buses 50 et sont disposées transversalement à la direction de défilement du substrat et donc selon l'extension la plus petite du substrat.

Selon l'écartement des rampes transversales 53, une ou plusieurs rampes sont actives pour projeter les solutions sur une surface suffisante du substrat en défilement.

Pour la copulvérisation de deux solutions, on préférera alimenter chaque rampe avec les deux solutions via deux conduits d'alimentation distincts en délivrant de manière partagée les buses de la rampe.

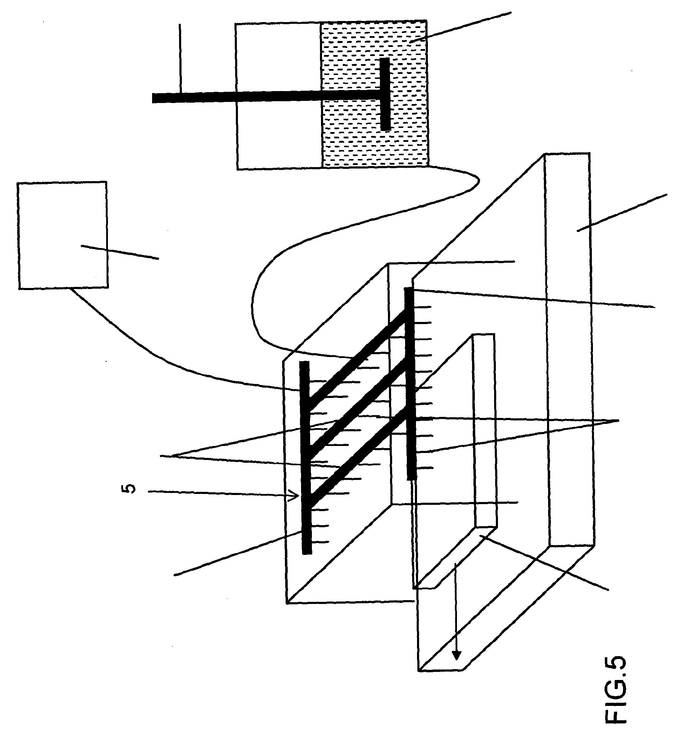

La troisième variante de réalisation de la figure 5 comporte au moins les deux rampes longitudinales 51 et 52 de la figure 3 auxquelles sont ajoutées une pluralité de rampes supplémentaires transversales 53.

Pour une copulvérisation de deux solutions, la première solution 7 est par exemple pulvérisée via les buses des rampes longitudinales 51 et 52, tandis que la seconde solution 8 est pulvérisée via les buses des rampes transversales 53. Une alimentation partagée des deux solutions sur une pluralité de buses d'une même rampe peut aussi être envisagée (non illustré).

Une couche SnO₂:F est un exemple de couche nécessitant une pulvérisation de deux solutions distinctes, une solution d'acide et une solution de zinc. La variante de réalisation de la figure 5 peut être préférée avec une alimentation distincte des deux solutions dans respectivement les rampes longitudinales et les rampes transversales.

La solution 8 d'acide chlorhydrique (HCl) est constituée d'eau et d'HCl selon de préférence une concentration volumique de 1 à 2 mol/l d'HCl pour une gravure de 200 nmd'épaisseur par exemple.

La solution 7 de zinc est constituée par de la poudre de zinc (particules entre 3 et 40 µm) dispersée dans de l'eau. Ce mélange peut être agité en continu par un système mécanique rotatif adapté 9 pour être délivrer dans les rampes d'alimentation des buses.

En variante, le mélange de zinc contient un additif organique ou minéral, par exemple métallique tel que de la poudre de fer ou de la silice pulvérulente, qui permet à la poudre de rester dispersée. Le mélange ainsi homogène peut alimenter les buses.

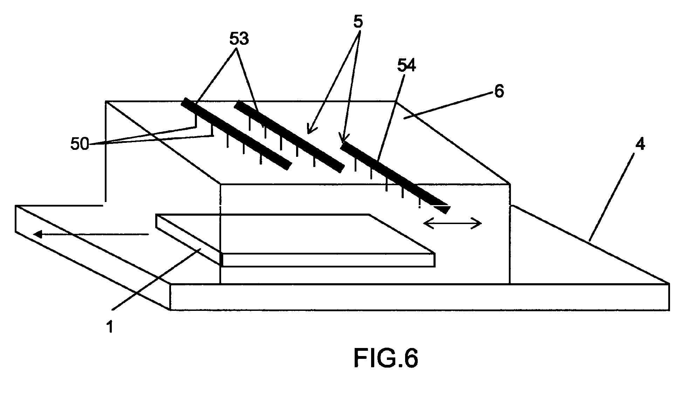

On peut également envisager une variante de réalisation pour laquelle certaines buses sont fixes, tandis que d'autres buses sont mobiles au-dessus du substrat, qui de préférence est stoppé en position fixe au moment de la pulvérisation (figure 6). Les buses fixes qui délivrent par exemple une première solution peuvent par exemple être supportées par au moins une rampe 53 s'étendant selon la plus petite extension du substrat. Les buses mobiles qui délivrent la seconde solution peuvent par exemple être supportées par une rampe 54 qui s'étend également selon la plus petite extension du substrat et qui est rendue mobile en effectuant des allers et retours au-dessus du substrat par des moyens appropriés de guidage, et à une hauteur sensiblement inférieure à la hauteur des buses fixes.

## Revendications

1. Dispositif pour graver chimiquement une couche à propriétés de conduction électrique (2) sur un substrat transparent (1 ), comportant des moyens de support (4) du substrat (1) et des moyens de projection (5) d'une solution, les moyens de projection (5) consistant en une multiplicité de buses (50) qui sont agencées au-dessus du substrat et qui sont destinées à projeter simultanément sur la couche à graver au moins deux solutions (7, 8), soit de manière indépendante l'une de l'autre, soit selon un mélange effectué au niveau des buses ou en amont de buses dans un laps de temps avant la projection ne dépassant pas trente secondes, ledit dispositif étant **caractérisé en ce que** les buses (50) sont portées par au moins une rampe oblongue (51, 52, 53).

2. Dispositif selon la revendication 1, **caractérisé en ce que** les moyens de projection (5) comportent au moins une rampe (51) qui s'étend selon l'extension la plus grande du substrat et correspond en longueur sensiblement à cette extension.

3. Dispositif selon la revendication 1, **caractérisé en ce que** les moyens de projection (5) comportent au moins deux rampes (51,52) qui s'étendent selon l'extension la plus grande du substrat et qui sont agencées selon un écartement correspondant sensiblement à l'extension la plus petite du substrat.

4. Dispositif selon la revendication 1, **caractérisé en ce que** les moyens de projection (5) comportent au moins une rampe (53) qui s'étend selon l'extension la plus petite du substrat et correspond en longueur sensiblement à cette extension.

5. Dispositif selon l'une des revendications 1 à 4, **caractérisé en ce que** les moyens de projection (5) comportent au moins deux rampes (51,52) qui s'étendent selon l'extension la plus grande du substrat et qui sont agencées selon un écartement correspondant sensiblement à l'extension la plus petite du substrat, ainsi qu'au moins une rampe supplémentaire (53) qui s'étend transversalement aux deux autres rampes (51, 52).

6. Dispositif selon l'une des revendications 1 à 5, **caractérisé en ce que** les buses (50) sont réparties de manière à couvrir une surface équivalente à la surface du substrat.

7. Dispositif selon l'une des revendications 1 à 6, **caractérisé en ce que** les buses (50) pulvérisent au moins une solution de manière continue ou alternative.

8. Dispositif selon l'une des revendications 1 à 7, **caractérisé en ce que** les solutions sont projetées pour un même substrat selon des cycles de délivrance.

9. Dispositif selon l'une quelconque des revendications 1 à 5, **caractérisé en ce que** chaque rampe comporte un conduit d'alimentation d'une solution distincte, les buses (50) d'une même rampe délivrant la même solution.

10. Dispositif selon l'une quelconque des revendications 1 à 5, **caractérisé en ce qu'**au moins une rampe comporte au moins deux conduits d'alimentation de respectivement deux solutions distinctes, qui sont respectivement délivrées dans la multitude de buses (50), de manière indépendante ou bien concomitamment.

11. Dispositif selon la revendication 5, **caractérisé en ce que** les deux rampes (51, 52) s'étendant selon l'extension la plus grande du substrat sont alimentées par une même solution, tandis que la ou les rampes supplémentaires transversales (53) sont alimentées par une autre solution distincte.

12. Dispositif selon l'une quelconque des revendications précédentes, **caractérisé en ce que** les moyens de support (4) du substrat sont aptes à défiler sous les buses (50) qui sont fixes, et/ou les buses (50) sont aptes défiler au-dessus du substrat qui est en position fixe ou qui défile.

13. Dispositif selon l'une quelconque des revendications précédentes, **caractérisé en ce que** le substrat est fixe, tandis que certaines buses sont fixes pour délivrer une première solution et d'autres buses sont mobiles pour délivrer une seconde solution.

14. Dispositif selon l'une quelconque des revendications précédentes, **caractérisé en ce que** les buses (50) sont disposées à une hauteur du substrat comprise entre 1 et quelques dizaines de centimètres.

15. Dispositif selon l'une quelconque des revendications précédentes, **caractérisé en ce qu'**il comporte un caisson (6) couvrant les buses et le substrat lors de la pulvérisation des solutions.

16. Dispositif selon l'une quelconque des revendications précédentes, **caractérisé en ce qu'**il est utilisé pour un substrat comportant une couche à base d'oxyde d'étain à graver et les buses (50) délivrent simultanément une solution d'acide chlorhydrique et une solution à base de zinc.

17. Dispositif selon la revendication 16, **caractérisé en ce que** la solution à base de zinc est une solution dans laquelle les particules de zinc sont dispersées dans de l'eau, la solution étant mélangée en continu par un système mécanique rotatif (9), lors de son alimentation jusqu'aux buses (50).

18. Dispositif selon l'une quelconque des revendications précédentes, **caractérisé en ce que** les moyens de projection (5) sont adaptés à délivrer une solution de rinçage, les moyens de projection pour le rinçage étant fixes ou mobiles au-dessus du substrat.

19. Procédé de gravure chimique d'une couche (2) à propriétés de conduction électrique, de type oxyde métallique dopé, sur un substrat transparent (1) de type verrier, comportant au moins une étape de dépôt d'un masque (3) sur la couche à graver, une étape d'attaque de la couche (2) dans les zones (2') dépourvues du masque qui consiste à mettre en contact les zones de la couche (2') avec une première solution (7) à pH acide ou à pH alcalin, et à projeter une seconde solution (8) de zinc ou respectivement d'aluminium, **caractérisé en ce que** la première solution (7) et la seconde solution (8) sont projetées simultanément sur les zones (2') dépourvues de masque.

20. Procédé selon la revendication 19, **caractérisé en ce que** les deux solutions sont pulvérisées simultanément de manière indépendante ou bien simultanément selon un mélange effectué au moment de la projection ou dans un laps de temps avant la projection ne dépassant pas les trente secondes.

21. Procédé selon la revendication 19 ou 20, **caractérisé en ce que** les deux solutions sont pulvérisées par une technique de spray.

22. Procédé selon l'une des revendications 19 à 21, **caractérisé en ce qu'**il grave des couches à base d'oxyde métallique dopé, notamment des couches à base d'oxyde d'étain dopé au fluor, à l'arsenic ou à l'antimoine, à base d'oxyde d'indium dopé à l'étain ITO.

23. Procédé selon l'une des revendications 19 à 22, **caractérisé en ce que** le zinc ou l'aluminium de la solution est en suspension dans un ou plusieurs solvants organiques et/ou aqueux éventuellement munis au moins d'additifs modificateurs de rhéologie.

24. Procédé selon l'une des revendications 19 à 23, **caractérisé en ce que** la première solution à pH acide ou à pH basique comprend au moins un solvant aqueux, alcoolique ou hydroalcoolique, et un acide fort du type HCl ou respectivement une base forte du type Na OH, et éventuellement des additifs du type surfactants.

25. Procédé selon l'une des revendications 19 à 24, **caractérisé en ce qu'**il comporte après l'étape d'attaque, un traitement de nettoyage du substrat (1) comportant la couche (2), et le retrait du masque (3).

26. Procédé l'une des revendications 19 à 25, **caractérisé en ce que** la phase de nettoyage consiste à rincer la couche (2), par spray ou par immersion du substrat (1), à l'aide d'une solution à base d'eau et/ou de solvants organiques.

27. Procédé selon la revendication 25 ou 26, **caractérisé en ce qu'**on effectue le retrait du masque (3) par dissolution dans un solvant approprié, notamment un solvant essentiellement organique, ou par traitement aux ultrasons, ou par ramollissement puis pelage par traction mécanique, ou par un traitement thermique.

28. Utilisation du dispositif selon l'une des revendications 1 à 18 à la fabrication d'électrodes/éléments conducteurs dans l'industrie verrière, notamment pour des vitrages chauffants, vitrages à antenne, dans l'industrie électronique, notamment pour des écrans émissifs du type écran plat tels que les écrans plasma ou pour les écrans tactiles, dans l'industrie des cellules photovoltaïques.

29. Utilisation du procédé selon l'une des revendications 19 à 27 à la fabrication d'électrodes/éléments conducteurs dans l'industrie verrière, notamment pour des vitrages chauffants, vitrages à antenne, dans l'industrie électronique, notamment pour des écrans émissifs du type écran plat tels que les écrans plasma ou pour les écrans tactiles, dans l'industrie des cellules photovoltaïques.

## Claims

1. A device for chemically etching a layer (2) having electrical conduction properties on a transparent substrate (1), which device comprises support means (4) for supporting the substrate (1) and spray means (5) for spraying a solution, the spray means (5) consisting of a multiplicity of nozzles (50) that are placed above the substrate and are intended to simultaneously spray onto the layer to be etched at least two solutions (7, 8), either independently of each other or as a mixture, mixed at the nozzles or upstream of the nozzles within a period of time before spraying that does not exceed thirty seconds, said device being **characterized in that** the nozzles (50) are supported by at least one elongate rail (51, 52, 53).

2. The device as claimed in claim 1, **characterized in that** the spray means (5) comprise at least one rail (51) that extends over the longest dimension of the substrate and corresponds, lengthwise, approximately to this dimension.

3. The device as claimed in claim 1, **characterized in that** the spray means (5) comprise at least two rails (51, 52) that extend over the longest dimension of the substrate and are spaced apart by a distance corresponding approximately to the shortest dimension of the substrate.

4. The device as claimed in claim 1, **characterized in that** the spray means (5) comprise at least one rail (53) that extends over the shortest dimension of the substrate and corresponds, lengthwise, approximately to this dimension.

5. The device as claimed in one of claims 1 to 4, **characterized in that** the spray means (5) comprise at least two rails (51, 52) that extend over the longest dimension of the substrate and are spaced apart by a distance corresponding approximately to the shortest dimension of the substrate, together with at least one additional rail (53) that extends transversely to the two other rails (51, 52).

6. The device as claimed in one of claims 1 to 5, **characterized in that** the nozzles (50) are distributed so as to cover an area equivalent to the area of the substrate.

7. The device as claimed in one of claims 1 to 6, **characterized in that** the nozzles (50) spray at least one solution continuously or alternately.

8. The device as claimed in one of claims 1 to 7, **characterized in that** the solutions are sprayed for any one substrate in delivery cycles.

9. The device as claimed in any one of claims 1 to 5, **characterized in that** each rail includes a line for supplying a separate solution, the nozzles (50) of any one rail delivering the same solution.

10. The device as claimed in any one of claims 1 to 5, **characterized in that** at least one rail has at least two lines for supplying respectively two separate solutions, which are respectively delivered to the multitude of nozzles (50), independently or concomitantly.

11. The device as claimed in claim 5, **characterized in that** the two rails (51, 52) extending along the longest dimension of the substrate are supplied with one and the same solution, whereas the transverse additional rail or rails (53) are supplied with another, separate, solution.

12. The device as claimed in any one of the preceding claims, **characterized in that** the means (4) for supporting the substrate are capable of running beneath the nozzles (50) which are stationary, and/or the nozzles (50) are capable of running above the substrate, which is in a stationary position or which is running.

13. The device as claimed in any one of the preceding claims, **characterized in that** the substrate is stationary, while certain nozzles for delivering a first solution are stationary nozzles and other nozzles for delivering a second solution are moving nozzles.

14. The device as claimed in any one of the preceding claims, **characterized in that** the nozzles (50) are placed at a height above the substrate of between one and a few tens of centimeters.

15. The device as claimed in any one of the preceding claims, **characterized in that** it includes a box (6) that covers the nozzles and the substrate while the solutions are being sprayed.

16. The device as claimed in any one of the preceding claims, **characterized in that** it is used for a substrate that includes a tin-oxide-based layer to be etched and the nozzles (50) simultaneously deliver a hydrochloric acid solution and a zinc-based solution.

17. The device as claimed in claim 16, **characterized in that** the zinc-based solution is a solution in which the zinc particles are dispersed in water, the solution being continuously mixed by a rotating mechanical system (9) as it is being supplied to the nozzles (50).

18. The device as claimed in any one of the preceding claims, **characterized in that** the spray means (5) are designed to deliver a rinsing solution, the spray means for the rinsing being stationary or moving above the substrate.

19. A process for chemically etching a layer (2) having electrical conduction properties, of the doped metal oxide type, on a transparent substrate (1) of the glass type, which comprises at least one step of depositing a mask (3) on the layer to be etched and a step of etching the layer (2) in the regions (2') not covered by the mask, which consists in bringing the regions (2') of the layer into contact with a first solution (7) at acid pH or alkaline pH and in spraying a second, zinc or aluminum, solution (8), **characterized in that** the first solution (7) and the second solution (8) are sprayed simultaneously onto the regions (2') not covered by the mask.

20. The process as claimed in claim 19, **characterized in that** the two solutions are sprayed simultaneously, either independently or simultaneously as a mixture, mixed at the time of spraying or within a period of time before spraying that does not exceed thirty seconds.

21. The process as claimed in either of claims 19 and 20, **characterized in that** the two solutions are sprayed in the form of droplets.

22. The process as claimed in one of claims 19 to 21, **characterized in that** it etches layers based on a doped metal oxide, especially layers based on tin oxide doped with fluorine, arsenic or antimony, or based on tindoped indium oxide (ITO).

23. The process as claimed in one of claims 19 to 22, **characterized in that** the zinc or aluminum of the solution is in suspension in one or more organic and/or aqueous solvents optionally provided with at least rheology-modifying additives.

24. The process as claimed in one of claims 19 to 23, **characterized in that** the first solution at acid pH or at basic pH comprises at least one aqueous, alcoholic or aqueous-alcoholic solvent, a strong acid of the HCl type or a strong base of the NaOH type respectively, and optionally additives of the surfactant type.

25. The process as claimed in one of claims 19 to 24, **characterized in that** it includes, after the etching step, a cleaning treatment, in order to clean the substrate (1) having the layer (2), and the removal of the mask (3).

26. The process as claimed in one of claims 19 to 25, **characterized in that** the cleaning phase consists in rinsing the layer (2), by spraying the substrate (1) with or immersing it in a solution based on water and/or organic solvents.

27. The process as claimed in claim 25 or 26, **characterized in that** the mask (3) is removed by dissolving it in a suitable solvent, in particular an essentially organic solvent, or by an ultrasonic treatment, or by softening the mask and then peeling it off by pulling on it, or by a heat treatment.

28. The use of the device as claimed in one of claims 1 to 18 for the manufacture of conducting electrodes/elements in the glass industry, especially for heated glass and antenna glass, in the electronics industry, especially for field-emission displays of the flat screen type, such as plasma displays, or for touch screens, and in the photovoltaic cell industry.

29. The use of the process as claimed in one of claims 19 to 27 for the manufacture of conducting electrodes/elements in the glass industry, especially for heated glass and antenna glass, in the electronics industry, especially for field-emission displays of the flat screen type, such as plasma displays, or for touch screens, and in the photovoltaic cell industry.

## Patentansprüche

1. Vorrichtung zum chemischen Ätzen einer elektrisch leitfähigen Schicht (2) auf einem transparenten Substrat (1), mit Mitteln (4) zum Tragen des Substrats (1) und Mitteln (5) zum Aufspritzen einer Lösung, wobei die Spritzmittel (5) aus einer Vielzahl von Düsen (50) bestehen, die oberhalb des Substrats angeordnet und dazu bestimmt sind, auf die zu ätzende Schicht wenigstens zwei Lösungen (7, 8) gleichzeitig aufzuspritzen, entweder unabhängig voneinander oder in einer Mischung, die im Bereich der Düsen oder stromaufwärts der Düsen in einem Zeitraum von nicht mehr als dreißig Sekunden vor dem Aufspritzen vollzogen wird, wobei die Vorrichtung **dadurch gekennzeichnet ist, dass** die Düsen (50) von wenigstens einer länglichen Verteilerleitung (51, 52, 53) getragen werden.

2. Vorrichtung nach Anspruch 1, **dadurch gekennzeichnet, dass** die Spritzmittel (5) wenigstens eine Verteilerleitung (51) aufweisen, die entlang der größten Erstreckung des Substrats verläuft und längenmäßig im wesentlichen dieser Erstreckung entspricht.

3. Vorrichtung nach Anspruch 1, **dadurch gekennzeichnet, dass** die Spritzmittel (5) wenigstens zwei Verteilerleitungen (51, 52) umfassen, die entlang der größten Erstreckung des Substrats verlaufen und die in einem Abstand angeordnet sind, der im wesentlichen der kleinsten Erstreckung des Substrats entspricht.

4. Vorrichtung nach Anspruch 1, **dadurch gekennzeichnet, dass** die Spritzmittel (5) wenigstens eine Verteilerleitung (53) aufweisen, die entlang der kleinsten Erstreckung des Substrats verläuft und längenmäßig im wesentlichen dieser Erstreckung entspricht.

5. Vorrichtung nach einem der Ansprüche 1 bis 4, **dadurch gekennzeichnet, dass** die Spritzmittel (5) wenigstens zwei Verteilerleitungen (51, 52) umfassen, die entlang der größten Erstreckung des Substrats verlaufen und die in einem Abstand angeordnet sind, der im wesentlichen der kleinsten Erstreckung des Substrats entspricht, sowie wenigstens eine zusätzliche Verteilerleitung (53) aufweisen, die quer zu den beiden anderen Verteilerleitungen (51, 52) verläuft.

6. Vorrichtung nach einem der Ansprüche 1 bis 5, **dadurch gekennzeichnet, dass** die Düsen (50) derart verteilt sind, dass sie eine der Oberfläche des Substrats entsprechende Fläche abdecken.

7. Vorrichtung nach einem der Ansprüche 1 bis 6, **dadurch gekennzeichnet, dass** die Düsen (50) wenigstens eine Lösung kontinuierlich oder abwechselnd versprühen.

8. Vorrichtung nach einem der Ansprüche 1 bis 7, **dadurch gekennzeichnet, dass** die Lösungen für ein gleiches Substrat in Abgabezyklen aufgespritzt werden.

9. Vorrichtung nach einem der Ansprüche 1 bis 5, **dadurch gekennzeichnet, dass** jede Verteilerleitung eine Leitung zum Zuführen einer gesonderten Lösung umfasst, wobei die Düsen (50) einer gleichen Verteilerleitung die gleiche Lösung liefern.

10. Vorrichtung nach einem der Ansprüche 1 bis 5, **dadurch gekennzeichnet, dass** wenigstens eine Verteilerleitung wenigstens zwei Leitungen zum Zuführen von jeweils zwei unterschiedlichen Lösungen umfasst, die unabhängig voneinander oder auch gleichzeitig jeweils in die Vielzahl von Düsen (50) abgegeben werden.

11. Vorrichtung nach Anspruch 5, **dadurch gekennzeichnet, dass** die zwei Verteilerleitungen (51, 52), die entlang der größten Erstreckung des Substrats verlaufen, mit einer gleichen Lösung beaufschlagt werden, während die zusätzliche oder zusätzlichen querverlaufende(n) Verteilerleitung(en) (53) mit einer weiteren gesonderten Lösung beaufschlagt werden.

12. Vorrichtung nach einem der vorhergehenden Ansprüche, **dadurch gekennzeichnet, dass** die Mittel (4) zum Tragen des Substrats geeignet sind, unter den feststehenden Düsen (50) vorbeizulaufen, und/oder dass die Düsen (50) geeignet sind, oberhalb des in fester Position befindlichen oder vorbeilaufenden Substrats vorbeizulaufen.

13. Vorrichtung nach einem der vorhergehenden Ansprüche, **dadurch gekennzeichnet, dass** das Substrat fest ist, während einige Düsen fest sind, um eine erste Lösung zu liefern und andere Düsen beweglich sind, um eine zweite Lösung zu liefern.

14. Vorrichtung nach einem der vorhergehenden Ansprüche, **dadurch gekennzeichnet, dass** die Düsen (50) in einer Höhe des Substrats angeordnet sind, die zwischen 1 und einigen zehn Zentimetern beträgt.

15. Vorrichtung nach einem der vorhergehenden Ansprüche, **dadurch gekennzeichnet, dass** sie einen Kasten (6) umfasst, welcher die Düsen und das Substrat während des Versprühens der Lösungen bedeckt.

16. Vorrichtung nach einem der vorhergehenden Ansprüche, **dadurch gekennzeichnet, dass** sie für ein Substrat mit einer zu ätzenden Schicht auf Zinnoxidbasis verwendet wird und dass die Düsen (50) gleichzeitig eine Salzsäurelösung und eine Lösung auf Zinkbasis liefern.

17. Vorrichtung nach Anspruch 16, **dadurch gekennzeichnet, dass** die Lösung auf Zinkbasis eine Lösung ist, bei der die Zinkteilchen in Wasser feinst verteilt sind, wobei die Lösung - während sie bis zu den Düsen (50) geführt wird - mittels eines mechanischen rotierenden Systems (9) fortlaufend gemischt wird.

18. Vorrichtung nach einem der vorhergehenden Ansprüche, **dadurch gekennzeichnet, dass** die Spritzmittel (5) geeignet sind, eine Spüllösung zu liefern, wobei die Spritzmittel für die Spülung fest oder oberhalb des Substrats beweglich sind.

19. Verfahren zum chemischen Ätzen einer elektrisch leitfähigen Schicht (2), von der Art dotiertes Metalloxid, auf einem transparenten glasartigen Substrat (1), umfassend wenigstens einen Schritt zum Aufbringen einer Maske (3) auf die zu ätzende Schicht, einen Schritt zum Ätzen der Schicht (2) in den nicht mit der Maske versehenen Bereichen (2'), der darin besteht, die Bereiche der Schicht (2') mit einer ersten Lösung (7) mit saurem pH-Wert oder alkalischem pH-Wert in Kontakt zu bringen und eine zweite Lösung (8) aus Zink bzw. aus Aluminium aufzuspritzen, **dadurch gekennzeichnet, dass** die erste Lösung (7) und die zweite Lösung (8) gleichzeitig auf die maskenlosen Bereiche (2') aufgespritzt werden.

20. Verfahren nach Anspruch 19, **dadurch gekennzeichnet, dass** die beiden Lösungen gleichzeitig unabhängig voneinander oder aber gleichzeitig in einer Mischung, die zum Zeitpunkt des Aufspritzens oder in einem Zeitraum von nicht mehr als dreißig Sekunden vor dem Aufspritzen vollzogen wird, versprüht werden.

21. Verfahren nach Anspruch 19 oder 20, **dadurch gekennzeichnet, dass** die beiden Lösungen mittels einer Spraytechnik versprüht werden.

22. Verfahren nach einem der Ansprüche 19 bis 21, **dadurch gekennzeichnet, dass** es Schichten auf der Basis von dotiertem Metalloxid, insbesondere Schichten auf der Basis von fluordotierten, arsendotierten oder antimondotierten Zinnoxid, auf der Basis von zinndotiertem Indiumoxid ITO ätzt.

23. Verfahren nach einem der Ansprüche 19 bis 22, **dadurch gekennzeichnet, dass** das Zink oder das Aluminium der Lösung in einem oder mehreren organischen und/oder wässrigen Lösungsmitteln, die eventuell wenigstens mit rheologieverändernden Additiven versehen sind, in Suspension ist.

24. Verfahren nach einem der Ansprüche 19 bis 23, **dadurch gekennzeichnet, dass** die erste Lösung mit saurem pH-Wert oder basischem pH-Wert wenigstens ein wässriges, alkoholisches oder hydroalkoholisches Lösungsmittel und eine starke Säure vom Typ HCl bzw. eine starke Base vom Typ Na OH sowie eventuell Zusätze vom Typ oberflächenaktive Mittel umfasst.

25. Verfahren nach einem der Ansprüche 19 bis 24, **dadurch gekennzeichnet, dass** es nach dem Ätzschritt eine Behandlung zum Reinigen des die Schicht (2) aufweisenden Substrats (1) sowie das Entfernen der Maske (3) umfasst.

26. Verfahren nach einem der Ansprüche 19 bis 25, **dadurch gekennzeichnet, dass** die Reinigungsphase darin besteht, die Schicht (2) durch Besprühen oder durch Eintauchen des Substrats (1), mit Hilfe einer Lösung auf Basis von Wasser und/oder organischen Lösungsmitteln zu spülen.

27. Verfahren nach Anspruch 25 oder 26, **dadurch gekennzeichnet, dass** das Entfernen der Maske (3) durch Auflösen in einem geeigneten Lösungsmittel, insbesondere einem im wesentlichen organischen Lösungsmittel, oder durch Ultraschallbehandlung oder mittels Aufweichen und anschließendem Abschälen durch mechanisches Ziehen oder mittels einer Wärmebehandlung vollzogen wird.

28. Verwendung der Vorrichtung nach einem der Ansprüche 1 bis 18 bei der Herstellung von Elektroden/leitenden Elementen in der Glasindustrie, insbesondere für Heizscheiben, Antennenscheiben, in der Elektronikindustrie, vor allem für Emissionsbildschirme von der Art Flachbildschirm, wie zum Beispiel Plasmabildschirme, oder für Touchscreens, in der Solarzellenindustrie.

29. Verwendung des Verfahrens nach einem der Ansprüche 19 bis 27 bei der Herstellung von Elektroden/leitenden Elementen in der Glasindustrie, insbesondere für Heizscheiben, Antennenscheiben, in der Elektronikindustrie, vor allem für Emissionsbildschirme von der Art Flachbildschirm, wie zum Beispiel Plasmabildschirme, oder für Touchscreens, in der Solarzellenindustrie.
